# EUROPÄISCHE PATENTSCHRIFT

(11) **EP 3 578 418 B1**
(45) Veröffentlichungstag und Bekanntmachung des Hinweises auf die Patenterteilung: **12.05.2021**
(21) Anmeldenummer: 19174329.3
(22) Anmeldetag: 14.05.2019
(51) Int. Cl.: B60R 16/023, B60R 16/03, H01H 85/20

(54) **KRAFTFAHRZEUGBORDNETZ, VERFAHREN ZUM BETREIBEN EINES DERARTIGEN KRAFTFAHRZEUGBORDNETZES SOWIE SICHERUNGSVORRICHTUNG FÜR EIN KRAFTFAHRZEUGBORDNETZ**
MOTOR VEHICLE ELECTRICAL SYSTEM, METHOD FOR OPERATING SAME, AND FUSEBOX FOR A MOTOR VEHICLE ELECTRICAL SYSTEM
RÉSEAU DE BORD DE VÉHICULE AUTOMOBILE, PROCÉDÉ DE FONCTIONNEMENT D'UN TEL RÉSEAU DE BORD DE VÉHICULE AUTOMOBILE AINSI QUE BOÎTIER DE FUSIBLES POUR UN RÉSEAU DE BORD DE VÉHICULE AUTOMOBILE

(30) Priorität: 04.06.2018 DE 102018208754
(43) Veröffentlichungstag der Anmeldung: 11.12.2019
(73) Patentinhaber: Volkswagen AG, 38440 Wolfsburg (DE)
(72) Erfinder: Kreath, Adrian, 30167 Hannover (DE)

(56) Entgegenhaltungen:
- WO-A1-2017/211586
- DE-A1-102016 111 690

## Beschreibung

Die Erfindung betrifft ein Kraftfahrzeugbordnetz, umfassend eine Batterie, mehrere Verbraucher, eine Primärsicherung und mehrere Pfade, über die die mit der Batterie elektrisch gekoppelte Primärsicherung seriell mit jeweils einem der Verbraucher elektrisch gekoppelt ist, wobei jeder Pfad zumindest eine von mehreren Sekundärsicherungen umfasst, ein Verfahren zum Betreiben eines derartigen Kraftfahrzeugbordnetzes sowie eine Sicherungsvorrichtung für ein derartiges Kraftfahrzeugbordnetz.

Gemäß dem internationalen Standard ISO 8820-2 müssen Sicherungspfade eine Selektivität aufweisen. Dies bedeutet, dass eine Sicherung, die relativ nah zu einer Fehlerstelle in einer elektrischen Schaltung angeordnet ist, aufgrund dieses Fehlers auslösen sollte und die Verbraucher der anderen Sicherungspfade der Schaltung weiter mit Energie versorgt werden sollten.

In der DE 10 2015 002 070 A1 wird eine Batteriezelle für eine Batterie eines Kraftfahrzeugs beschrieben, die mittels einer Steuereinheit in einen Schaltzustand überführbar ist, in welchem eine elektrische Leitung zwischen dem galvanischen Element der Batterie und einem elektrischen Anschluss unterbrochen ist. Mit dem entsprechenden Schaltelement der Batteriezelle ist eine Mehrfachauslösung des Schaltelements möglich, das heißt, das Unterbrechen der elektrisch leitenden Verbindung innerhalb der Batterie ist reversibel. Das Schaltelement selbst ist hierbei beispielsweise als Halbleiterelement ausgebildet und innerhalb der Batteriezelle angeordnet.

In der DE 10 2015 002 149 A1 ist ebenfalls eine Batteriezelle für eine Batterie eines Kraftfahrzeugs beschrieben, die ebenfalls ein Schaltelement umfasst, welches zum Unterbrechen und Herstellen einer elektrisch leitenden Verbindung zwischen dem galvanischen Element der Batteriezelle und einem elektrischen Anschluss der Batteriezelle ausgebildet ist. Diese Batteriezelle ist dazu ausgelegt, dass bei einem Kurzschluss die elektrisch leitende Verbindung innerhalb der Batterie sicher getrennt werden kann. Bei zu hohen Temperaturen kann jedoch eine automatische Freischaltung oder ein automatisches Abschalten der Batteriezelle zur Absicherung erfolgen.

In der DE 10 2009 007 969 A1 wird eine Kurzschlussschutzvorrichtung zur Begrenzung beziehungsweise zur Abschaltung von einem Kurzschlussstrom in einem Hochenergiegleichstromnetz beschrieben. Diese Schutzvorrichtung umfasst unter anderem eine Überwachungs- und Steuerungseinrichtung zur Überwachung des Stromes durch einen Schalter sowie zum Öffnen des Schalters der Schutzvorrichtung, wenn der Strom durch den Schalter einen vorgegebenen Grenzwert überschreitet. Die Kurzschlussschutzvorrichtung kann hierbei in eine Hochleistungsbatterieanlage mit mehreren parallel geschalteten Batteriemodulen integriert sein, von denen jedes einzelne Batteriemodul eine eigene Schutzvorrichtung aufweist.

Die gattungsgebende DE 37 02 517 A1 zeigt eine Schaltungsanordnung zur Stromversorgung einer Vielzahl von Verbraucher, die mit derselben Spannungsquelle verbunden sind. Für jeden Verbraucher ist ein zwischen ihm und der Spannungsquelle angeordneter Betriebszustandsschalter vorgesehen. Außerdem umfasst die Schaltungsanordnung eine Sicherheitseinrichtung, die beim Auftreten eines Überstroms oder einer Unterspannung Schäden verhindern kann.

Die GB 2 182 812 A zeigt eine Schaltungsanordnung mit einem zentralen schnell schaltenden Halbleiterschalter, wobei die Schaltungsanordnung mehrere Unterschaltkreise umfasst, die jeweils einen einzelnen Schalter sowie einen Störungsdetektor aufweisen. Wenn in einem der Unterschaltkreise eine Störung erfasst wird, wird mittels des Halbleiterschalters die Energieversorgung aller Unterschaltkreise unterbrochen, der von der Störung betroffenen Unterschaltkreis isoliert und anschließend mittels des Halbleiterschalters die Energieversorgung der restlichen Unterschaltkreise wiederhergestellt.

Ein zum autonomen Fahren ausgelegtes Kraftfahrzeug, das über eine Lithium-Ionen-Batterie verfügt, weist in der Regel eine besonders schnell abschaltbare Sicherung für diese Batterie auf. Bei einem technischen Defekt eines Verbrauchers eines derartigen Kraftfahrzeugs würde diese besonders schnell abschaltbare Sicherung der Lithium-Ionen-Batterie ausgelöst werden. Hierbei würde in der Regel sofort das gesamte Kraftfahrzeugbordnetz abgeschaltet werden. In dieser Situation ist also keine Selektivität der Sicherungspfade des Kraftfahrzeugbordnetzes gewährleistet.

Es ist die Aufgabe der Erfindung, eine Lösung bereitzustellen, mittels welcher ein gattungsgemäßes Kraftfahrzeugbordnetz mit selektiven Sicherungspfaden betrieben werden kann.

Diese Aufgabe wird durch ein Kraftfahrzeugbordnetz, ein Verfahren zum Betreiben eines derartigen Kraftfahrzeugbordnetzes sowie eine Sicherungsvorrichtung für ein derartiges Kraftfahrzeugbordnetz gemäß den unabhängigen Patentansprüchen gelöst.

Das erfindungsgemäße Kraftfahrzeugbordnetz umfasst eine Batterie, mehrere Verbraucher, eine Primärsicherung und mehrere Pfade, über die die mit der Batterie elektrisch gekoppelte Primärsicherung seriell mit jeweils einem der Verbraucher elektrisch gekoppelt ist, wobei jeder Pfad zumindest eine von mehreren Sekundärsicherungen umfasst. Die Primärsicherung und die Sekundärsicherungen des Kraftfahrzeugbordnetzes sind als reversible Sicherungen ausgebildet. Zudem ist eine Steuervorrichtung des Kraftfahrzeugbordnetzes dazu eingerichtet, auf diese Sicherungen zuzugreifen, zu bestimmen, ob ein Fehler in dem Kraftfahrzeugbordnetz aufgetreten ist, der zumindest für eine der Sicherungen, die von zumindest zwei der Pfade umfasst ist, ein Auslösekriterium erfüllt, und in diesem Fall die Sicherungen derart selektiv anzusteuern, dass die fehlerfreien Pfade identifiziert und anschließend die Sicherungen in den fehlerfreien Pfaden wieder eingeschaltet werden.

In dem erfindungsgemäßen Kraftfahrzeugbordnetz ist also eine Batterie des Kraftfahrzeugs, bei der es sich beispielsweise um eine Lithium-Ionen-Batterie handelt, mit den einzelnen Verbrauchern des Kraftfahrzeugs elektrisch gekoppelt. Das Kraftfahrzeugbordnetz weist zudem mehrere Sicherungen auf, die jeweils als reversible Sicherungen ausgebildet sind. Bei diesen reversiblen Sicherungen handelt es sich beispielsweise um elektronische Sicherungen, die von einer zentralen Steuereinheit, der Steuervorrichtung des Kraftfahrzeugbordnetzes, jeweils einzeln, das heißt selektiv, angesteuert werden können.

Betreffend die Sicherungen des Kraftfahrzeugbordnetzes werden zwei Gruppen von Sicherungen unterschieden. Zum einen befindet sich direkt hinter der Batterie in serieller elektrischer Kopplung die sogenannte Primärsicherung. Alternativ dazu kann es sich bei der Primärsicherung um eine beispielsweise in die Lithium-Ionen-Batterie des Kraftfahrzeugs integrierte Sicherung, das heißt eine Selbstschutzsicherung der Batterie, handeln. Die Primärsicherung wiederum ist über mehrere Pfade, die jeweils zumindest eine von mehreren sogenannten Sekundärsicherungen umfassen, mit jeweils einem der Verbraucher des Kraftfahrzeugs elektrisch gekoppelt. Jeder Verbraucher des Kraftfahrzeugs, wie beispielsweise eine Klimaanlage, eine Beleuchtungseinrichtung oder eine Sitzheizung des Kraftfahrzeugs, ist also über einen der Pfade des Kraftfahrzeugbordnetzes seriell mit mindestens einer der Sekundärsicherungen, der Primärsicherung und der Batterie des Kraftfahrzeugs gekoppelt. Die einzelnen Verbraucher befinden sich somit jeweils am Ende einer seriellen Schaltung aus zumindest einer der Sekundärsicherungen, der Primärsicherung und der Batterie. Es können allerdings auch mehrere Verbraucher mit einer Sekundärsicherung gekoppelt sein.

Bei einem Auftreten eines Fehlers, wie beispielsweise einem Defekt eines der Verbraucher oder einem Überlastfall im Kraftfahrzeugbordnetz oder in einem der Verbraucher, kann es aufgrund eines relativ trägen Reaktionsverhaltens der einzelnen Sicherungen, das heißt der Primärsicherung und der Sekundärsicherungen, zu einem Abschalten des gesamten oder zumindest eines Teils des Kraftfahrzeugbordnetzes kommen. Zu einem solchen zumindest teilweisen Abschalten des Kraftfahrzeugbordnetzes kommt es immer dann, wenn zumindest eine der Sicherungen ausgelöst wird, die Bestandteil von mindestens zwei Pfaden zwischen der Batterie und den einzelnen Verbrauchern des Kraftfahrzeugs ist. Bei einem derartigen Fehler im Kraftfahrzeugbordnetz, der das sogenannte Auslösekriterium für einzelne Sicherungen des Kraftfahrzeugbordnetzes erfüllt, kommt es somit zumindest zu einem teilweisen Abschalten des Kraftfahrzeugbordnetzes.

Die Steuervorrichtung des Kraftfahrzeugbordnetzes ist jedoch dazu eingerichtet, in einer derartigen Situation die einzelnen Sicherungen selektiv anzusteuern und die einzelnen Pfade selektiv zu überprüfen, um letztendlich die Pfade zu identifizieren, in denen ein Fehler vorliegt. Dies kann beispielweise erfolgen, indem zunächst alle Sicherungen in den Pfaden, die die ausgelöste Sicherung umfassen, ausgeschaltet werden. Im Rahmen des Überprüfens werden daraufhin die Sicherungen eines ersten dieser Pfade wieder eingeschaltet. Falls dieser Pfad als fehlerfrei identifiziert wird, werden diese Sicherungen jedoch wieder ausgeschaltet. Daraufhin werden analog dazu die Sicherungen der anderen Pfade überprüft. Alternativ kann dieses Vorgehen mit allen Pfaden und nicht nur mit den Pfaden, die die ausgelöste Sicherung umfassen, durchgeführt werden. Sobald zumindest die von dem Auslösen der Sicherung betroffenen Pfade hinsichtlich des Fehlers, der zum Erfüllen des Auslösekriteriums geführt hat, überprüft wurden, werden alle als fehlerfrei identifizierten Pfade wieder eingeschaltet. Das Kraftfahrzeugbordnetz kann alternativ, nachdem die beschriebene Wiedereinschaltstrategie durchgeführt wurde, sukzessive wieder eingeschaltet werden, das heißt indem die entsprechenden Sicherungen nacheinander eingeschaltet werden. Durch das im Rahmen des Überprüfens der einzelnen Pfade erfolgte sogenannte Hereinschalten in den Fehler im Kraftfahrzeugbordnetz kann die genaue Fehlerstelle identifiziert werden und die betroffenen Pfade können lokalisiert und vom restlichen Kraftfahrzeugbordnetz isoliert werden, sodass letztlich die von dem Fehler nicht betroffenen Verbraucher wieder mit Energie aus der Batterie versorgt werden können.

Im Gegensatz zu Kraftfahrzeugbordnetzen, in denen beispielsweise Schmelzsicherungen zur Absicherung des Kraftfahrzeugbordnetzes in einem Überlastfall des Kraftfahrzeugbordnetzes oder einzelner Verbraucher vorgesehen sind, erfolgt erfindungsgemäß die Absicherung des Kraftfahrzeugbordnetzes mithilfe von wiedereinschaltbaren Sicherungen. Dies ermöglicht, dass, wenn zumindest eine Sicherung, die mehrere der Pfade des Kraftfahrzeugbordnetzes umfasst, ausgelöst wurde, durch selektives Ansteuern der einzelnen Sicherungen, das heißt deren selektives Ein- und Ausschalten, alle fehlerfreien Pfade identifiziert und anschließend die Sicherungen in diesen Pfaden wieder eingeschaltet werden können. Mithilfe des beschriebenen Kraftfahrzeugbordnetzes ist somit die Selektivität bei Sicherungspfaden in Kraftfahrzeugbordnetzen erfüllbar. Zudem kann mit diesen Kraftfahrzeugbordnetzen, nachdem ein Fehler aufgetreten ist, durch den das Auslösekriterium erfüllt wurde, relativ zeitnah und zuverlässig der fehlerbehaftete Pfad identifiziert werden, was bei der Behebung des Fehlers innerhalb des Kraftfahrzeugbordnetzes besonders vorteilhaft ist. Zudem können die nicht fehlerbehafteten Teile des Kraftfahrzeugbordnetzes nach dem Fehlerfall besonders zeitnah wieder betrieben werden, da die Sicherungen in den fehlerfreien Pfaden wieder eingeschaltet werden.

Erfindungsgemäß ist es vorgesehen, dass die Sekundärsicherungen in mehreren Sicherungsebenen, die jeweils mehrere parallelgeschaltete Sekundärsicherungen umfassen, derart angeordnet sind, dass einzelne Sekundärsicherungen in einer Sicherungsebene mit mehreren Sekundärsicherungen einer anderen Sicherungsebene seriell elektrisch gekoppelt sind und somit von mehreren der Pfade umfasst werden. Im Kraftfahrzeugbordnetz ist es also möglich, dass mehrere Ebenen von Sekundärsicherungen zur Absicherung des Kraftfahrzeugbordnetzes vorhanden sind, die jeweils aus mehreren parallel geschalteten Sekundärsicherungen bestehen. Beispielsweise weist eine erste Sicherungsebene drei Sekundärsicherungen auf, die jeweils mit der Primärsicherung elektrisch gekoppelt sind. Die drei Sekundärsicherungen sind zudem jeweils mit drei Sekundärsicherungen einer zweiten Sicherungsebene elektrisch gekoppelt. Diese zweite Sicherungsebene umfasst also insgesamt neun Sekundärsicherungen, die wiederum jeweils mit mindestens einem der Verbraucher des Kraftfahrzeugs gekoppelt sind. Hierdurch ergeben sich drei Zweige von Pfaden, die jeweils vier Sekundärsicherungen, eine aus der ersten Sicherungsebene und drei aus der zweiten Sicherungsebene, umfassen. Falls das Auslösekriterium erfüllt ist, fällt daher häufig nur ein einzelner Zweig aus Pfaden des Kraftfahrzeugbordnetzes aus, dessen Pfade daraufhin überprüft werden. Nur wenn es zu einem Auslösen der Primärsicherung selbst kommt, werden alle Zweige bestehend aus allen einzelnen Pfaden des Kraftfahrzeugbordnetzes ausgeschaltet, sodass das gesamte Kraftfahrzeugbordnetz, das heißt alle Pfade, untersucht werden müssen, um anschließend die Sicherungen in fehlerfreien Pfaden wieder einschalten zu können. Diese Anordnung der Sekundärsicherungen ermöglicht daher ein besonders gezieltes Überprüfen der Pfade zum Identifizieren der fehlerfreien Pfade.

Erfindungsgemäß ist es zudem vorgesehen, dass die Steuervorrichtung dazu eingerichtet ist, zum Identifizieren der fehlerfreien Pfade nur die Pfade mit der zumindest einen Sicherung, die das Auslösekriterium erfüllt hat, in einer vorgegebenen Reihenfolge einzeln zu überprüfen und anschließend die Sicherungen aller dabei erkannten fehlerfreien Pfade wieder einzuschalten. Es ist also ein sukzessives Überprüfen der Pfade durchführbar. Hierbei werden die einzelnen Pfade in der vorgegebenen Reihenfolge, die beispielsweise abhängig von einer Relevanz der einzelnen Verbraucher des Kraftfahrzeugbordnetzes hinsichtlich einer Sicherheit von Fahrzeuginsassen festgelegt ist, überprüft, beispielsweise durch gezieltes Ein- und Ausschalten einzelner Sicherungen. Unter Berücksichtigung der vorgegebenen Reihenfolge ist somit ein besonders sinnvolles Überprüfen und anschließendes Einschalten der Sicherungen der fehlerfreien Pfade möglich. Zudem kann auch das Einschalten der Sicherungen in den als fehlerfrei erkannten Pfaden gleichzeitig oder nacheinander in der vorgegebenen Reihenfolge erfolgen.

Alternativ dazu ist es erfindungsgemäß vorgesehen, dass die Steuervorrichtung dazu eingerichtet ist, zum Identifizieren der fehlerfreien Pfade nur die Pfade mit der zumindest einen Sicherung, für die das Auslösekriterium erfüllt ist, in einer vorgegebenen Reihenfolge einzeln zu überprüfen und, sobald ein Pfad mit der zumindest einen Sicherung, für die das Auslösekriterium erfüllt ist, identifiziert wurde, die Sicherungen aller anderen Pfade einzuschalten. Das Identifizieren der fehlerfreien Pfade kann somit auch in einer verkürzten Form erfolgen. Diese sieht vor, dass beispielsweise zunächst alle Sicherungen ausgeschaltet werden und sobald durch selektives Ein- und Ausschalten ein Pfad identifiziert wurde, der eine Sicherung umfasst, für die das Auslösekriterium erfüllt ist, dieser Pfad als die Fehlerquelle angenommen wird und daraufhin das Überprüfen der einzelnen Pfade beendet wird. Alle anderen Pfade, sowohl die, die bereits als fehlerfrei identifiziert wurden, als auch die, die bisher noch nicht überprüft wurden, werden daraufhin wieder eingeschaltet. Es ist somit ein besonders schnell durchführbares Identifizieren der fehlerfreien Pfade möglich. Hierbei wird vorausgesetzt, dass häufig nur in einem der Pfade ein tatsächlicher Fehler vorliegt, es jedoch aufgrund der elektrischen Kopplung der Sicherungen miteinander, das heißt dadurch, dass häufig eine Sicherung von mehreren Pfaden des Kraftfahrzeugbordnetzes umfasst wird, mehrere Pfade aufgrund des Fehlers und der ausgelösten Sicherung ausgeschaltet wurden. Eine alternative, besonders schnelle Vorgehensweise zum Identifizieren der fehlerfreien Pfade kann von einem "Quicksort"-Algorithmus abgeleitet werden, einem häufig im Bereich der Informatik zum Sortieren von Zahlen verwendeter Algorithmus. Das heißt, es werden nicht immer nur Sicherungen in einem einzelnen Pfad selektiv ein- und ausgeschaltet.

In weiterer vorteilhafter Ausgestaltung der Erfindung ist es vorgesehen, dass die Steuervorrichtung dazu ausgelegt ist, das Auslösekriterium als erfüllt anzunehmen, wenn eine vorgegebene Maximalleistung, ein vorgegebener Maximalstrom und/oder eine vorgegebene Maximalspannung in einer der Sekundärsicherungen und/oder der Primärsicherung überschritten wird und diese auslöst. Das Auslösekriterium ist somit beispielsweise bei einem Überlastfall im Kraftfahrzeugbordnetz oder in einem der Verbraucher erfüllt. Beispielsweise kann es zu einem Kurzschluss gegen Masse im Kraftfahrzeugbordnetz oder in dem Verbraucher gekommen sein. Aufgrund der damit verbundenen relativ hohen Ströme und/oder Spannungen, das heißt aufgrund der damit verbundenen erhöhten Last im Kraftfahrzeugbordnetz, kann ein Überschreiten entsprechender vorgegebener Maximalwerte im Auslösen einzelner Sicherungen im Kraftfahrzeugbordnetz resultieren. Sobald eine Sicherung, die von zumindest zwei der Pfade des Kraftfahrzeugbordnetzes umfasst ist, das genannte Auslösekriterium erfüllt, wird von der Steuervorrichtung die selektive Ansteuerung umfassend das Ein- und Ausschalten einzelner Sicherungen zum Identifizieren der fehlerfreien Pfade sowie das anschließende Einschalten der identifizierten fehlerfreien Pfade durchgeführt. Der Steuervorrichtung liegen somit Maximalwerte hinsichtlich des Stroms, der Spannung und der Leistung in den einzelnen Pfaden des Kraftfahrzeugbordnetzes vor, die derart dimensioniert sind, dass die Verbraucher und andere Komponenten des Kraftfahrzeugbordnetzes vor Defekten durch eine zu hohe Belastung durch Ströme, Spannungen und Leistungen geschützt sind.

In weiterer vorteilhaften Ausgestaltung der Erfindung ist es vorgesehen, dass die Steuervorrichtung eine Speichereinheit aufweist, die dazu eingerichtet ist, zu speichern, welche der Pfade als fehlerfrei identifiziert wurden und diese Information für ein Einschalten der Sicherungen zu berücksichtigen. Die Steuervorrichtung hinterlegt somit in einer dafür vorgesehenen Einheit, der sogenannten Speichereinheit, die Informationen über die Pfade, die bereits im Rahmen der Identifizierung der fehlerfreien Pfade untersucht wurden. In der Speichereinheit liegen somit Informationen darüber bereit, welcher Pfad fehlerbehaftet beziehungsweise nicht fehlerbehaftet ist. Basierend auf den dort gespeicherten Fehlerzuständen der einzelnen Pfade wird im nächsten Schritt, beim Wiedereinschalten der Sicherungen der fehlerfreien Pfade, sichergestellt, dass nur die tatsächlich fehlerfreien Pfade wieder eingeschaltet werden. Mit Hilfe der Speicherung dieser Informationen wird somit erreicht, dass es bei einem Wiedereinschalten von Pfaden des Kraftfahrzeugbordnetzes nicht zu einem erneuten Auslösen der Sicherungen aufgrund des gleichen Fehlers im Kraftfahrzeugbordnetz kommt.

In weiterer vorteilhafter Ausgestaltung der Erfindung ist es vorgesehen, dass die Primärsicherung und die Sekundärsicherungen als elektronische Sicherungen und/oder elektronische Sicherungslasttrennschalter ausgebildet sind. Bei den Sicherungen des Kraftfahrzeugbordnetzes kann es sich somit beispielsweise um Schutzvorrichtungen handeln, die einen Stromkreis bei Kurzschluss oder Überlastung selbsttätig abschalten und eine Form von Überstromschutzeinrichtung darstellen, das heißt um sogenannte elektronische Sicherungen. Zusätzlich oder alternativ dazu kann es sich bei den Sicherungen auch um sogenannte Lasttrennschalter, das heißt Schalter, die aus einer Kombination von jeweils einem Lastschalter und einem Trennschalter bestehen, handeln. Zusätzlich oder alternativ dazu kann es sich bei der elektronischen Sicherung auch um ein Relais handeln. Bei der Wahl der Sicherung für die Primärsicherung und die Sekundärsicherungen ist jedoch besonders zu berücksichtigen, dass die Sicherung reversibel, das heißt erneut ein- und ausschaltbar ist. Hierdurch wird ein Identifizieren und anschließendes erneutes Einschalten von fehlerfreien Pfaden durch selektives Ein- und Ausschalten der einzelnen Sicherungen möglich.

In weiterer vorteilhafter Ausgestaltung der Erfindung ist es vorgesehen, dass die Batterie des Kraftfahrzeugbordnetzes als Hochspannungsbatterie, insbesondere als Lithium-Ionen-Batterie ausgebildet ist. Das Kraftfahrzeugbordnetz kann alternativ dazu auch eine Bleibatterie, wie sie häufig in Kraftfahrzeugen verbaut wird, umfassen oder generell eine Batterie, die für einen Niedervoltbereich von typischerweise zwölf Volt ausgelegt ist. Besonders häufig findet man jedoch in Kraftfahrzeugen, die insbesondere zum autonomen Fahren ausgelegt sind, Lithium-Ionen-Batterien, unter anderem da diese eine höhere Sicherheitsstufe, wie beispielsweise eine höhere ISO 26262 (Road vehicle - Functional safety) Norm, erfüllen als herkömmliche Bleibatterien. Eine Lithium-Ionen-Batterie weist im Vergleich zu anderen Batterietypen eine besonders hohe spezifische Energie auf. Jedoch erfordert diese in den meisten Anwendungen elektronische Schutzschaltungen, da Lithium-Ionen-Batterien sowohl auf Tiefenentladung als auch auf Überladung empfindlich reagieren. Das beschriebene Kraftfahrzeugbordnetz umfasst daher besonders bevorzugt eine Lithium-Ionen-Batterie, da in einem solchen Kraftfahrzeugbordnetz die beschriebenen mehreren Sicherungen, die Primärsicherung sowie mehrere Sekundärsicherungen, vorhanden sind. In einem solchen Kraftfahrzeugbordnetz, das mehrere Pfade aufweist, ist zur Erfüllung der ISO 8820-2 Vorschriften ein selektives Ansteuern der einzelnen Sicherungen zum Identifizieren der fehlerfreien Pfade bei einem Fehler innerhalb des Kraftfahrzeugbordnetzes besonders sinnvoll.

Die im Zusammenhang mit dem erfindungsgemäßen Kraftfahrzeugbornetz vorgestellten bevorzugten Ausgestaltungen und deren Vorteile gelten entsprechend, soweit anwendbar, für ein erfindungsgemäßes Verfahren zum Betreiben eines Kraftfahrzeugbordnetzes. Das Verfahren ist somit für ein Kraftfahrzeugbordnetz vorgesehen, dass eine Batterie, mehrere Verbraucher, eine Primärsicherung, mehrere Pfade, über die die mit der Batterie elektrisch gekoppelte Primärsicherung seriell mit jeweils einem Verbraucher gekoppelt ist, wobei hier der Pfad zumindest einer von mehreren Sekundärsicherungen umfasst, sowie eine Steuervorrichtung, die dazu eingerichtet ist, auf die als reversible Sicherung ausgebildete Primärsicherung und die Sekundärsicherungen zuzugreifen, umfasst. Die Sekundärsicherungen sind in mehreren Sicherungsebenen, die jeweils mehrere parallel geschaltete Sekundärsicherungen umfassen, derart angeordnet, dass einzelne Sekundärsicherungen in einer der Sicherungsebene mit mehreren Sekundärsicherungen einer anderen Sicherungsebene seriell elektrisch gekoppelt sind und daher von mehreren der Pfade umfasst werden. Das Verfahren umfasst die folgenden Schritte der Steuervorrichtung: Es erfolgt ein Bestimmen, ob ein Fehler in dem Kraftfahrzeugbordnetz aufgetreten ist, der zumindest für eine der Sicherungen, die von mindestens zwei der Pfade umfasst ist, ein Auslösekriterium erfüllt. Falls für zumindest eine Sicherung das Auslösekriterium erfüllt ist, erfolgt ein selektives Ansteuern der Sicherungen zum Identifizieren der fehlerfreien Pfade, wobei nur die Pfade mit der zumindest einen Sicherung, für die das Auslösekriterium erfüllt ist, in einer vorgegebenen Reihenfolge einzeln überprüft werden. Anschließend erfolgt ein Einschalten der Sicherungen aller dabei erkannten fehlerfreien Pfade. Alternativ dazu erfolgt ein Einschalten der Sicherungen aller anderen Pfade, sobald ein Pfad mit der zumindest einen Sicherung, für die das Auslösekriterium erfüllt ist, identifiziert wurde. Das Verfahren ist somit zum Betreiben des oben beschriebenen Kraftfahrzeugbordnetzes ausgelegt. Die auf die einzelnen Sicherungen, das heißt die Primärsicherung und die mehreren Sekundärsicherungen, zugreifende Steuervorrichtung erkennt, dass ein Fehler im Bordnetz aufgetreten ist, steuert daraufhin selektiv durch gezieltes Ein- und Ausschalten einzelne Sicherungen an, um die nicht von dem Fehler betroffenen Pfade des Kraftfahrzeugbordnetzes zu erkennen, und schaltet letztendlich, nachdem diese Überprüfung abgeschlossen ist, die Sicherung der fehlerfreien Pfade wieder ein. Mit dem erfindungsgemäßen Verfahren wird somit der weiterhin funktionsfähige Teil des Kraftfahrzeugbordnetzes, das heißt nicht von dem Fehler betroffenen Verbraucher des Kraftfahrzeugs, wieder eingeschaltet.

Erfindungsgemäß ist zudem eine Sicherungsvorrichtung für ein Kraftfahrzeugbordnetz, wie es oben beschrieben wurde, vorgesehen. Die im Zusammenhang mit dem erfindungsgemäßen Kraftfahrzeugbornetz vorgestellten bevorzugten Ausgestaltungen und deren Vorteile gelten entsprechend, soweit anwendbar, für die erfindungsgemäße Sicherungsvorrichtung. Die Sicherungsvorrichtung umfasst zumindest die mehreren Pfade, über die die mit der Batterie elektrisch gekoppelte Primärsicherung des Kraftfahrzeugbordnetzes seriell mit jeweils einem der Verbraucher des Kraftfahrzeugs elektrisch gekoppelt ist, wobei jeder Pfad zumindest eine von mehreren Sekundärsicherungen umfasst, sowie die Steuervorrichtung des Kraftfahrzeugbordnetzes. Die Sekundärsicherungen sind in mehreren Sicherungsebenen, die jeweils mehrere parallel geschaltete Sekundärsicherungen umfassen, derart angeordnet, dass einzelne Sekundärsicherungen in einer der Sicherungsebene mit mehreren Sekundärsicherungen einer anderen Sicherungsebene seriell elektrisch gekoppelt sind und daher von mehreren der Pfade umfasst werden. Bei dieser Steuereinrichtung des Kraftfahrzeugbordnetzes handelt es sich beispielsweise um einen Microcontroller, in dem die verschiedenen Schritte des oben beschriebenen Verfahrens als entsprechende Steuerbefehle hinterlegt sind. Bei den Sekundärsicherungen in den Pfaden der Sicherungsvorrichtung handelt es sich um reversible Sicherungen, wie beispielsweise elektronische Sicherungen und/oder elektronische Sicherungslasttrennschalter. Die Sicherungsvorrichtung verfügt zudem über eine Schnittstelle, über die sie auf die außerhalb der Sicherungsvorrichtung angeordnete Primärsicherung zugreifen kann. Alternativ dazu kann die Primärsicherung, falls diese beispielsweise nicht in die Batterie integriert ist, auch ein Bestandteil der Sicherungsvorrichtung sein. Die erfindungsgemäße Sicherungsvorrichtung kann somit zum Schutz einer Batterie eines Kraftfahrzeugs und zur Gewährleistung der Selektivität bei Sicherungspfaden in einem Kraftfahrzeugbordnetz in ein solches Kraftfahrzeugbordnetz integriert werden.

Zu der Erfindung gehören auch Weiterbildungen des erfindungsgemäßen Verfahrens, die Merkmale aufweisen, wie sie bereits im Zusammenhang mit den Weiterbildungen des erfindungsgemäßen Kraftfahrzeugs beschrieben worden sind. Aus diesem Grund sind die entsprechenden Weiterbildungen des erfindungsgemäßen Verfahrens hier nicht noch einmal beschrieben.

Im Folgenden ist ein Ausführungsbeispiel der Erfindung beschrieben. Hierzu zeigt:
- Fig. 1: eine schematische Darstellung eines Kraftfahrzeugs mit einem Kraftfahrzeugbordnetz;
- Fig. 2: eine schematische Darstellung eines Kraftfahrzeugbordnetzes; und
- Fig. 3: in schematischer Darstellung einen Signalflussgraphen für ein Verfahren zum Betreiben eines Kraftfahrzeugbordnetzes.

Bei dem im Folgenden erläuterten Ausführungsbeispiel handelt es sich um eine bevorzugte Ausführungsform der Erfindung. Bei dem Ausführungsbeispiel stellen die beschriebenen Komponenten der Ausführungsform jeweils einzelne, unabhängig voneinander zu betrachtende Merkmale der Erfindung dar, welche die Erfindung jeweils auch unabhängig voneinander weiterbilden. Daher soll die Offenbarung auch andere als die im Ausführungsbeispiel dargestellten Kombinationen der Merkmale der Ausführungsformen umfassen. Des Weiteren ist die beschriebene Ausführungsform auch durch weitere der bereits beschriebenen Merkmale der Erfindung ergänzbar.

In den Figuren sind funktionsgleiche Elemente jeweils mit denselben Bezugszeichen versehen.

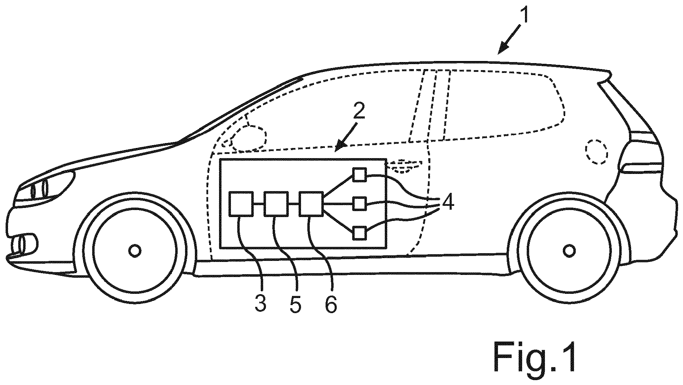

In Fig. 1 ist ein Kraftfahrzeug 1 skizziert, das ein Kraftfahrzeugbordnetz 2 umfasst. Das Kraftfahrzeugbordnetz 2 umfasst eine Batterie 3 sowie mehrere Verbraucher 4, wie beispielsweise eine Klimaanlage, eine Sitzheizung und ein Radiosystem. Diese Verbraucher 4 werden unter anderem von der Batterie 3 mit elektrischer Energie versorgt. Zwischen der Batterie 3 und den einzelnen Verbrauchern 4 sind zudem eine Primärsicherung 5 sowie eine Sicherungsvorrichtung 6 in das Kraftfahrzeugbordnetz 2 integriert, und zwar in die einzelnen Versorgungspfade der Verbraucher 4. Bei der Primärsicherung 5 handelt es sich beispielsweise um eine in die Batterie 3 integrierte Sicherung, wie einen Selbstschutz der Batterie 3. Die Batterie 3 selbst ist beispielsweise als Lithium-Ionen-Batterie, insbesondere als Hochspannungsbatterie für das Kraftfahrzeug 1, ausgebildet. Das Kraftfahrzeug 1 ist bevorzugt zum autonomen Fahren ausgelegt. In derartigen Kraftfahrzeugen 1, die unter anderem dazu ausgelegt sind, ohne einen Fahrer vollautonom zu fahren, ist ein Bordnetz, wie das mit mehreren Sicherungskomponenten, der Primärsicherung 5 und der zusätzlichen Sicherungsvorrichtung 6, ausgestattete Kraftfahrzeugbordnetz 2 besonders sinnvoll.

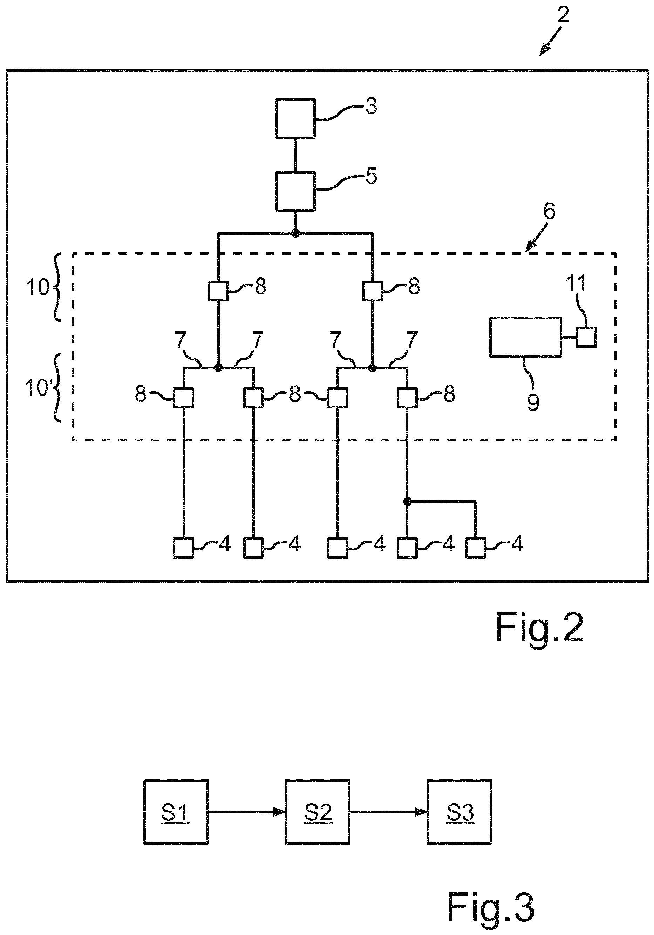

In Fig. 2 ist das Kraftfahrzeugbordnetz 2 detaillierter skizziert. Die Sicherungsvorrichtung 6 des Kraftfahrzeugbordnetzes 2 umfasst mehrere Komponenten. Zum einen umfasst sie mehrere Pfade 7, über die die mit der Batterie 3 elektrisch gekoppelte Primärsicherung 5 seriell mit jeweils einem der Verbraucher 4 elektrisch gekoppelt ist, wobei jeder dieser Pfade 7 zumindest eine von mehreren Sekundärsicherungen 8 umfasst. Sowohl die Primärsicherung 5 als auch die Sekundärsicherungen 8 sind als reversible Sicherungen, beispielsweise als elektronische Sicherungen oder als elektronische Sicherungslasttrennschalter, ausgebildet und können von einer Steuervorrichtung 9 des Kraftfahrzeugbordnetzes 2 ein- und ausgeschaltet werden. Die entsprechenden Kommunikationsverbindungen zum Datenaustausch zwischen der Primärsicherung 5 beziehungsweise den Sekundärsicherungen 8 und der Steuervorrichtung 9 sind in der Fig. 2 nicht skizziert.

Die Sekundärsicherungen 8 können hierbei in mehreren Sicherungsebenen 10, 10' angeordnet sein. Jede dieser Sicherungsebenen 10, 10' umfasst mehrere parallel geschaltete Sekundärsicherungen 8. Die Sekundärsicherungen 8 sind hierbei derart angeordnet, dass einzelne Sekundärsicherungen 8 in der Sicherungsebene 10 mit mehreren Sekundärsicherungen 8 der Sicherungsebene 10' seriell elektrisch gekoppelt sind und somit von mehreren der Pfaden 7 umfasst werden. Die beiden Sekundärsicherungen 8 in der Sicherungsebene 10 sind hier mit jeweils zwei Sekundärsicherungen 8 der Sicherungsebene 10' seriell elektrisch gekoppelt. Die insgesamt sechs Sekundärsicherungen 8 der Sicherungsvorrichtung 6 sind also auf zwei Sicherungsebenen 10, 10' verteilt, so dass sich insgesamt zwei Zweige von Pfaden 7 unterscheiden lassen, jeweils einer pro Sekundärsicherung 8 der Sicherungsebene 10, wobei jeder Zweig mindestens zwei der Verbraucher 4 umfasst. Es ist möglich, dass die Pfade 7 von mehreren Verbrauchern 4 dieselben Sekundärsicherungen 8 umfassen, also mehrere Verbraucher 4 mit jeweils einer Sekundärsicherung 8 der Sicherungsebene 10' seriell elektrisch gekoppelt sind.

Alternativ zur skizzierten Sicherungsvorrichtung 6 kann die Sicherungsvorrichtung 6 im Kraftfahrzeug 1 räumlich verteilt sein, beispielsweise mittels mehrere, im Kraftfahrzeug 1 verteilter Sicherungsverteiler und der räumlich getrennt angeordneten Steuervorrichtung 9. Hierdurch ergeben sich räumlich im Kraftfahrzeug verteilte Sicherungsebenen 10 und 10'.

Bei der Steuervorrichtung 9 handelt es sich beispielsweise um einen Microcontroller, der zudem eine Speichereinheit 11 aufweist, in der Informationen zu den einzelnen Pfaden 7 gespeichert werden.

In Fig. 3 sind die einzelnen Verfahrensschritte skizziert, die im Rahmen des Verfahrens zum Betreiben des Kraftfahrzeugbordnetzes 2 durchgeführt werden. In einem ersten Schritt S1 wird zunächst von der Steuervorrichtung 9 bestimmt, ob ein Fehler in dem Kraftfahrzeugbordnetz 2 aufgetreten ist, der zumindest für eine der Sicherungen, die von zumindest zwei der Pfade 7 umfasst ist, ein Auslösekriterium erfüllt. Bei diesem Auslösekriterium handelt es sich beispielsweise um eine vorgegebene Maximalleistung, einen vorgegebenen Maximalstrom oder eine vorgegebene Maximalspannung. Sobald dieser so festgesetzte Maximalwert in einer der Sekundärsicherungen 8 oder in der Primärsicherung 5 überschritte wird, wird die entsprechende Sicherung ausgelöst. Falls es sich bei der ausgelösten Sicherung um eine der Sekundärsicherungen 8, die jeweils von mehreren Pfaden 7 umfasst wird, oder um die Primärsicherung 5 handelt, kommt es zu einem Ausschalten von mehreren Verbrauchern 4 und somit einem Abschalten von mehreren Pfaden 7 des Kraftfahrzeugbordnetzes 2. Da jedoch nicht alle Verbraucher 4 der derart betroffenen Pfade 7 tatsächlich fehlerbehaftet sind, erfolgt im Schritt S2 ein selektives Ansteuern der einzelnen Sicherungen, das heißt der betroffenen Sekundärsicherungen 8 sowie der Primärsicherung 5 zum Identifizieren aller fehlerfreien Pfade 7 des Kraftfahrzeugbordnetzes 2. Dies kann beispielweise erfolgen, indem zunächst alle Sicherungen in den Pfaden 7, die die ausgelöste Sicherung umfassen, ausgeschaltet werden. Im Rahmen des Überprüfens werden daraufhin die Sicherungen eines ersten dieser Pfade 7 wieder eingeschaltet. Falls dieser Pfad 7 als fehlerfrei identifiziert wird, werden diese Sicherungen jedoch wieder ausgeschaltet. Daraufhin werden analog dazu die Sicherungen der anderen Pfade 7 überprüft. Alternativ kann dieses Vorgehen mit allen Pfaden 7 und nicht nur mit den Pfaden 7, die die ausgelöste Sicherung umfassen, durchgeführt werden. Dieses Identifizieren der fehlerfreien Pfade 7 erfolgt in einer vorgegebenen Reihenfolge, in der die Sicherungen von jeweils einem der Pfade 7 selektiv ein- und ausgeschaltet werden. Die dabei gewonnen Informationen über die untersuchten Pfade 7 werden in der Speichereinheit 11 hinterlegt, das heißt dort wird gespeichert welcher Pfad 7 mit welchen Sicherungen fehlerfrei beziehungsweise fehlerbehaftet ist.

In einem dritten Schritt S3 des Verfahrens erfolgt ein Einschalten der Sicherungen in den zuvor als fehlerfrei identifizierten und gespeicherten Pfaden 7. Es ist somit Ziel des Verfahrens, so viele Pfade 7 des Kraftfahrzeugbordnetzes 2 wieder einzuschalten, das heißt die Sekundärsicherungen 8 in diesen Pfaden 7 sowie die Primärsicherung 5 wieder einzuschalten, sodass ein möglichst großer Teil des Kraftfahrzeugbordnetzes 2, das heißt möglichst viele Verbraucher 4, wieder funktionsfähig sind und mit elektrischer Energie aus der Batterie 3 versorgt werden. Er erfolgt also ein sukzessives Überprüfen der Pfade 7 sowie ein anschließendes Einschalten des fehlerfreien Teils des Kraftfahrzeugbordnetzes 2.

Alternativ dazu ist es möglich, dass das Überprüfen der Pfade 7 hinsichtlich des Fehlers bereits abgebrochen wird, sobald ein fehlerbehafteter Pfad 7 identifiziert wurde. Die Sicherung von diesem fehlerbehafteten Pfad 7 wird daraufhin ausgeschaltet gelassen, wohingegen die Sicherungen in allen anderen Pfaden 7 einschaltet werden. Da in der Regel nur in einem Pfad 7 ein Fehler, der zum Erfüllen des Auslösekriteriums geführt hat, vorhanden ist, kann somit das beschriebene Verfahren zum Betreiben eines Kraftfahrzeugbordnetzes 2 abgekürzt und besonders zeitsparend durchgeführt werden. Falls es jedoch weitere Pfade 7 gibt, die von dem das Auslösekriterium erfüllenden Fehlers betroffen sind, kommt es zu einem erneuten Ausfall des Kraftfahrzeugbordnetzes 2 beziehungsweise des betroffenen Teils des Kraftfahrzeugbordnetzes 2. Sollte dies der Fall sein, muss eine erneute Überprüfung beziehungsweise Identifizierung der fehlerfreien Pfade 7 erfolgen.

Insgesamt zeigen die Beispiele, dass nach dem Auftreten eines Fehlers im Kraftfahrzeugbordnetz 2 und dem darauf folgenden Abschalten zumindest eines Teils des Kraftfahrzeugbordnetzes 2 die als reversible Sicherungen ausgeführten Sicherungen, die Primärsicherung 5 und die Sekundärsicherungen 8, in allen als fehlerfrei identifizierten Pfaden 7 wieder eingeschaltet sind. Hierfür wird im Rahmen des Identifizierens der fehlerfreien Pfade 7 eventuell in den Fehler hineingeschaltet, indem die Sicherungen von fehlerbehafteten Pfaden 7 zunächst ausgeschalten und dann wieder eingeschaltet werden, die daraufhin wieder ausgelöst werden. Allerdings kann dadurch die genaue Fehlerstelle im Kraftfahrzeugbordnetz 2 identifiziert werden. Nach der Lokalisierung des Fehlers im Kraftfahrzeugbordnetz 2 kann der fehlerbehaftete Pfad 7 isoliert und die Sicherungen aller fehlerfreien Pfade 7 können wieder eingeschaltet werden. Alle fehlerfrei verwendbaren Verbraucher 4 des Kraftfahrzeugs 1 werden also letztendlich wieder mit elektrischer Energie versorgt.

### Bezugszeichenliste

- 1: Kraftfahrzeug
- 2: Kraftfahrzeugbordnetz
- 3: Batterie
- 4: Verbraucher
- 5: Primärsicherung
- 6: Sicherungsvorrichtung
- 7: Pfad
- 8: Sekundärsicherung
- 9: Steuervorrichtung
- 10, 10': Sicherungsebene
- 11: Speichereinheit
- S1, S2, S3: Schritte

## Patentansprüche

1. Kraftfahrzeugbordnetz (2) umfassend
- eine Batterie (3),
- mehrere Verbraucher (4),
- eine Primärsicherung (5),
- mehrere Pfade (7), über die die mit der Batterie (3) elektrisch gekoppelte Primärsicherung (5) seriell mit jeweils einem der Verbraucher (4) elektrisch gekoppelt ist, wobei jeder Pfad (7) zumindest eine von mehreren Sekundärsicherungen (8) umfasst,
wobeidie Primärsicherung (5) und die Sekundärsicherungen (8) als reversible Sicherungen ausgebildet sind und eine Steuervorrichtung (9) des Kraftfahrzeugbordnetzes (2) dazu eingerichtet ist, auf diese Sicherungen zuzugreifen, zu bestimmen, ob ein Fehler in dem Kraftfahrzeugbordnetz (2) aufgetreten ist, der zumindest für eine der Sicherungen, die von zumindest zwei der Pfade (7) umfasst ist, ein Auslösekriterium erfüllt, und in diesem Fall die Sicherungen derart selektiv anzusteuern, dass die fehlerfreien Pfade (7) identifiziert und anschließend die Sicherungen in den fehlerfreien Pfaden (7) wieder eingeschaltet werden,
**dadurch gekennzeichnet, dass**
- die Sekundärsicherungen (8) in mehreren Sicherungsebenen (10, 10'), die jeweils mehrere parallel geschaltete Sekundärsicherungen (8) umfassen, derart angeordnet sind, dass einzelne Sekundärsicherungen (8) in einer Sicherungsebene (10) mit mehreren Sekundärsicherungen (8) einer anderen Sicherungsebene (10') seriell elektrisch gekoppelt sind und daher von mehreren der Pfade (7) umfasst werden, und
- die Steuervorrichtung (9) dazu eingerichtet ist, zum Identifizieren der fehlerfreien Pfade (7) nur die Pfade (7) mit der zumindest einen Sicherung, für die das Auslösekriterium erfüllt ist, in einer vorgegebenen Reihenfolge einzeln zu überprüfen und:
• anschließend die Sicherungen aller dabei erkannten fehlerfreien Pfade (7) wieder einzuschalten, oder
• sobald ein Pfad (7) mit der zumindest einen Sicherung, für die das Auslösekriterium erfüllt ist, identifiziert wurde, die Sicherungen aller anderen Pfade (7) einzuschalten.

2. Kraftfahrzeugbordnetz (2) nach Anspruch 1,
**dadurch gekennzeichnet, dass**
die Steuervorrichtung (9) dazu ausgelegt ist, das Auslösekriterium als erfüllt anzunehmen, wenn eine vorgegebene Maximalleistung, ein vorgegebener Maximalstrom und/oder eine vorgegebene Maximalspannung in einer der Sekundärsicherungen (8) und/oder der Primärsicherung (5) überschritten wird und diese auslöst.

3. Kraftfahrzeugbordnetz (2) nach einem der vorhergehenden Ansprüche,
**dadurch gekennzeichnet, dass**
die Steuervorrichtung (9) eine Speichereinheit (11) aufweist, die dazu eingerichtet ist, zu speichern, welche der Pfade (7) als fehlerfrei identifiziert wurden, und diese Information für ein Einschalten der Sicherungen zu berücksichtigen.

4. Kraftfahrzeugbordnetz (2) nach einem der vorhergehenden Ansprüche,
**dadurch gekennzeichnet, dass**
die Primärsicherung (5) und die Sekundärsicherungen (8) als elektronische Sicherungen und/oder elektronische Sicherungslasttrennschalter ausgebildet sind.

5. Kraftfahrzeugbordnetz (2) nach einem der vorhergehenden Ansprüche,
**dadurch gekennzeichnet, dass**
die Batterie (3) des Kraftfahrzeugbordnetzes (2) als Hochspannungsbatterie, insbesondere als Lithium-Ionen-Batterie, ausgebildet ist.

6. Verfahren zum Betreiben eines Kraftfahrzeugbordnetzes (2) umfassend eine Batterie (3), mehrere Verbraucher (4), eine Primärsicherung (5), mehrere Pfade (7), über die die mit der Batterie (3) elektrisch gekoppelte Primärsicherung (5) seriell mit jeweils einem der Verbraucher (4) elektrisch gekoppelt ist, wobei jeder Pfad (7) zumindest eine von mehreren Sekundärsicherungen (8) umfasst, sowie eine Steuervorrichtung (9), die dazu eingerichtet ist, auf die als reversible Sicherungen ausgebildete Primärsicherung (5) und die Sekundärsicherungen (8) zuzugreifen, wobei die Sekundärsicherungen (8) in mehreren Sicherungsebenen (10, 10'), die jeweils mehrere parallel geschaltete Sekundärsicherungen (8) umfassen, derart angeordnet sind, dass einzelne Sekundärsicherungen (8) in einer Sicherungsebene (10) mit mehreren Sekundärsicherungen (8) einer anderen Sicherungsebene (10') seriell elektrisch gekoppelt sind und daher von mehreren der Pfade (7) umfasst werden,
umfassend die folgenden Schritte der Steuervorrichtung (9):
(a) Bestimmen, ob ein Fehler in dem Kraftfahrzeugbordnetz (2) aufgetreten ist, der zumindest für eine der Sicherungen, die von zumindest zwei der Pfade (7) umfasst ist, ein Auslösekriterium erfüllt (S1),
(b) falls für zumindest eine der Sicherungen das Auslösekriterium erfüllt ist, selektives Ansteuern der Sicherungen zum Identifizieren der fehlerfreien Pfade (7) (S2), wobei nur die Pfade (7) mit der zumindest einen Sicherung, für die das Auslösekriterium erfüllt ist, in einer vorgegebenen Reihenfolge einzeln überprüft werden,
(c) anschließend Einschalten der Sicherungen aller dabei erkannten fehlerfreien Pfaden (7) oder Einschalten der Sicherungen aller anderen Pfade (7), sobald ein Pfad (7) mit der zumindest einen Sicherung, für die das Auslösekriterium erfüllt ist, identifiziert wurde (S3).

7. Sicherungsvorrichtung (6) für ein Kraftfahrzeugbordnetz (2) nach einem der Ansprüche 1 bis 5,
**dadurch gekennzeichnet, dass**
die Sicherungsvorrichtung (6) zumindest die mehreren Pfade (7), über die die mit der Batterie (3) elektrisch gekoppelte Primärsicherung (5) des Kraftfahrzeugbordnetzes (2) seriell mit jeweils einem der Verbraucher (4) des Kraftfahrzeugbordnetzes (2) elektrisch gekoppelt ist, wobei jeder Pfad (7) zumindest eine von mehreren Sekundärsicherungen (8) umfasst, sowie die Steuervorrichtung (9) des Kraftfahrzeugbordnetzes (2) umfasst, wobei die Sekundärsicherungen (8) in mehreren Sicherungsebenen (10, 10'), die jeweils mehrere parallel geschaltete Sekundärsicherungen (8) umfassen, derart angeordnet sind, dass einzelne Sekundärsicherungen (8) in einer der Sicherungsebene (10) mit mehreren Sekundärsicherungen (8) einer anderen Sicherungsebene (10') seriell elektrisch gekoppelt sind und daher von mehreren der Pfade (7) umfasst werden.

## Claims

1. Motor vehicle on-board power supply system (2) comprising
- a battery (3),
- a plurality of consumers (4),
- a primary fuse (5),
- a plurality of paths (7) via which the primary fuse (5), which is electrically coupled to the battery (3), is electrically coupled in series with each one of the consumers (4), wherein each path (7) comprises at least one of a plurality of secondary fuses (8),
wherein the primary fuse (5) and the secondary fuses (8) are designed as reversible fuses and a control device (9) of the motor vehicle on-board power supply system (2) is configured to access said fuses to determine whether a fault has arisen in the motor vehicle on-board power supply system (2), said fault satisfying a triggering criterion at least for one of the fuses comprised by at least two of the paths (7), and, in this case, to selectively actuate the fuses in such a way that the fault-free paths (7) are identified and the fuses in the fault-free paths (7) are subsequently switched on again, **characterized in that**
- the secondary fuses (8) are arranged in a plurality of fuse layers (10, 10'), which each comprise a plurality of parallel-connected secondary fuses (8), in such a way that individual secondary fuses (8) in one of the fuse layers (10) are electrically coupled in series with a plurality of secondary fuses (8) of another fuse layer (10') and are therefore comprised by a plurality of the paths (7), and
- the control device (9) is configured, for the purpose of identifying the fault-free paths (7), to individually check only the paths (7) having the at least one fuse for which the triggering criterion is satisfied in a prescribed order and:
• to subsequently switch on the fuses of all the fault-free paths (7) identified in the process again, or
• as soon as a path (7) having the at least one fuse for which the triggering criterion is satisfied has been identified, to switch on the fuses of all the other paths (7).

2. Motor vehicle on-board power supply system (2) according to Claim 1,
**characterized in that**
the control device (9) is designed to assume the triggering criterion as satisfied when a prescribed maximum power, a prescribed maximum current and/or a prescribed maximum voltage in one of the secondary fuses (8) and/or the primary fuse (5) is exceeded and triggers said primary fuse.

3. Motor vehicle on-board power supply system (2) according to either of the preceding claims,
**characterized in that**
the control device (9) has a storage unit (11), which is configured to store which of the paths (7) has been identified as fault-free and to take this information into account for switching on the fuses.

4. Motor vehicle on-board power supply system (2) according to one of the preceding claims,
**characterized in that**
the primary fuse (5) and the secondary fuses (8) are designed as electronic fuses and/or electronic fused load disconnectors.

5. Motor vehicle on-board power supply system (2) according to one of the preceding claims,
**characterized in that**
the battery (3) of the motor vehicle on-board power supply system (2) is designed as a high-voltage battery, in particular as a lithium-ion battery.

6. Method for operating a motor vehicle on-board power supply system (2) comprising a battery (3), a plurality of consumers (4), a primary fuse (5), a plurality of paths (7) via which the primary fuse (5), which is electrically coupled to the battery (3), is electrically coupled in series with each one of the consumers (4), wherein each path (7) comprises at least one of a plurality of secondary fuses (8), and a control device (9), which is configured to access the primary fuse (5) and the secondary fuses (8) designed as reversible fuses, wherein the secondary fuses (8) are arranged in a plurality of fuse layers (10, 10'), which each comprise a plurality of parallel-connected secondary fuses (8), in such a way that individual secondary fuses (8) in one of the fuse layers (10) are electrically coupled in series with a plurality of secondary fuses (8) of another fuse layer (10') and are therefore comprised by a plurality of the paths (7),
comprising the following steps of the control device (9):
(a) determining whether a fault has arisen in the motor vehicle on-board power supply system (2), said fault satisfying a triggering criterion at least for one of the fuses comprised by at least two of the paths (7) (S1),
(b) if the triggering criterion is satisfied for at least one of the fuses, selectively actuating the fuses in order to identify the fault-free paths (7) (S2), wherein only the paths (7) having the at least one fuse for which the triggering criterion is satisfied are individually checked in a prescribed order,
(c) subsequently switching on the fuses of all the fault-free paths identified in the process (7) or switching on the fuses of all the other paths (7) as soon as a path (7) having the at least one fuse for which the triggering criterion is satisfied has been identified (S3).

7. Fuse device (6) for a motor vehicle on-board power supply system (2) according to one of Claims 1 to 5,
**characterized in that**
the fuse device (6) comprises at least the plurality of paths (7) via which the primary fuse (5), which is electrically coupled to the battery (3), of the motor vehicle on-board power supply system (2) is electrically coupled in series with each one of the consumers (4) of the motor vehicle on-board power supply system (2), wherein each path (7) comprises at least one of a plurality of secondary fuses (8), and comprises the control device (9) of the motor vehicle on-board power supply system (2), wherein the secondary fuses (8) are arranged in a plurality of fuse layers (10, 10'), which each comprise a plurality of parallel-connected secondary fuses (8), in such a way that individual secondary fuses (8) in one of the fuse layers (10) are electrically coupled in series with a plurality of secondary fuses (8) of another fuse layer (10') and are therefore comprised by a plurality of the paths (7).

## Revendications

1. Réseau de bord de véhicule automobile (2), comprenant
- une batterie (3),
- plusieurs consommateurs (4),
- un fusible primaire (5),
- plusieurs trajets (7) par lesquels le fusible primaire (5) couplé électriquement à la batterie (3) est couplé électriquement en série avec respectivement l'un des consommateurs (4), chaque trajet (7) comprenant au moins l'un de plusieurs fusibles secondaires (8),
le fusible primaire (5) et les fusibles secondaires (8) étant réalisés sous forme de fusibles réversibles, et un dispositif de commande (9) du réseau de bord de véhicule automobile (2) est aménagé pour accéder à ces fusibles afin de déterminer si dans le réseau de bord de véhicule automobile (2) un défaut est apparu qui satisfait à un critère de déclenchement pour au moins l'un des fusibles inclus sur au moins deux des trajets (7), et dans ce cas, pour piloter les fusibles sélectivement de telle sorte que les trajets exempts de défaut (7) sont identifiés, et ensuite les fusibles sur les trajets exempts de défaut (7) sont réenclenchés,
**caractérisé en ce que**
- les fusibles secondaires (8) dans plusieurs plans de fusibles (10, 10"), qui comprennent respectivement plusieurs fusibles secondaires (8) connectés en parallèle, sont disposés de telle sorte que des fusibles secondaires (8) individuels dans un plan de fusible (10) sont couplés électriquement en série avec plusieurs fusibles secondaires (8) d'un autre plan de fusibles (10"), et sont donc inclus sur plusieurs trajets (7), et
- afin d'identifier les trajets exempts de défaut (7), le dispositif de commande (9) est aménagé pour contrôler individuellement dans un ordre prédéfini uniquement les trajets (7) comprenant ledit au moins un fusible pour lequel le critère de déclenchement est satisfait, et :
• ensuite, pour réenclencher les fusibles de tous les trajets exempts de défaut (7) reconnus à cette occasion, ou
• dès qu'un trajet (7) a été identifié qui comprend ledit au moins un fusible pour lequel le critère de déclenchement est satisfait, pour enclencher les fusibles de tous les autres trajets (7) .

2. Réseau de bord de véhicule automobile (2) selon la revendication 1, **caractérisé en ce que** le dispositif de commande (9) est conçu pour considérer le critère de déclenchement comme satisfait si une puissance maximale prédéfinie, un courant maximal prédéfini et/ou une tension maximale prédéfinie sont dépassés dans l'un des fusibles secondaires (8) et/ou du fusible primaire (5) et les déclenchent.

3. Réseau de bord de véhicule automobile (2) selon l'une quelconque des revendications précédentes, **caractérisé en ce que** le dispositif de commande (9) présente une unité de stockage (11) qui est aménagée pour stocker ceux des trajets (7) ayant été identifiés comme exempts de défaut, et pour tenir compte de ces informations pour enclencher les fusibles.

4. Réseau de bord de véhicule automobile (2) selon l'une quelconque des revendications précédentes, **caractérisé en ce que** le fusible primaire (5) et les fusibles secondaires (8) sont réalisés sous forme de fusibles électroniques et/ou d'interrupteurs-sectionneurs à fusibles électroniques.

5. Réseau de bord de véhicule automobile (2) selon l'une quelconque des revendications précédentes, **caractérisé en ce que** la batterie (3) du réseau de bord de véhicule automobile (2) est réalisée sous forme de batterie haute tension, en particulier de batterie lithium-ion.

6. Procédé permettant de faire fonctionner un réseau de bord de véhicule automobile (2) qui comprend une batterie (3), plusieurs consommateurs (4), un fusible primaire (5), plusieurs trajets (7) par lesquels le fusible primaire (5) couplé électriquement à la batterie (3) est couplé électriquement en série avec respectivement l'un des consommateurs (4), chaque trajet (7) comprenant au moins l'un de plusieurs fusibles secondaires (8), ainsi qu'un dispositif de commande (9) qui est aménagé pour accéder au fusible primaire (5) et aux fusibles secondaires (8) réalisés sous forme de fusibles réversibles, les fusibles secondaires (8) étant disposés sur plusieurs plans de fusibles (10, 10'), qui comprennent respectivement plusieurs fusibles secondaires (8) connectés en parallèle, de telle sorte que des fusibles secondaires individuels (8) dans un plan de fusibles (10) sont couplés électriquement en série avec plusieurs fusibles secondaires (8) d'un autre plan de fusibles (10'), et sont donc inclus sur plusieurs des trajets (7),
comprenant les étapes suivantes du dispositif de commande (9) :
(a) déterminer si dans le réseau de bord de véhicule automobile (2) un défaut est apparu qui satisfait à un critère de déclenchement (S1) pour au moins l'un des fusibles qui sont inclus sur au moins deux des trajets (7),
(b) si le critère de déclenchement est satisfait pour au moins l'un des fusibles, piloter sélectivement les fusibles afin d'identifier les trajets exempts de défaut (7) (S2), seuls les trajets (7) comprenant ledit au moins un fusible, pour lequel le critère de déclenchement est satisfait, étant contrôlés individuellement dans un ordre prédéfini,
(c) ensuite enclencher les fusibles de tous les trajets exempts de défaut (7) reconnus à cette occasion, ou enclencher les fusibles de tous les autres trajets (7) dès qu'un trajet (7) a été identifié (S3) qui comprend ledit au moins un fusible pour lequel le critère de déclenchement est satisfait.

7. Boîtier de fusibles (6) pour un réseau de bord de véhicule automobile (2) selon l'une quelconque des revendications 1 à 5,
**caractérisé en ce que** le boîtier de fusibles (6) comprend au moins les plusieurs trajets (7) par lesquels le fusible primaire (5) couplé électriquement à la batterie (3) du réseau de bord de véhicule automobile (2) est couplé électriquement en série avec respectivement l'un des consommateurs (4) du réseau de bord de véhicule automobile (2), chaque trajet (7) comprenant au moins l'un de plusieurs fusibles secondaires (8), ainsi que le dispositif de commande (9) du réseau de bord de véhicule automobile (2), dans lequel les fusibles secondaires (8) dans plusieurs plans de fusibles (10, 10"), qui comprennent respectivement plusieurs fusibles secondaires (8) connectés en parallèle, sont disposés de telle sorte que des fusibles secondaires (8) individuels dans l'un des plans de fusibles (10) sont couplés électriquement en série avec plusieurs fusibles secondaires (8) d'un autre plan de fusibles (10'), et sont donc inclus sur plusieurs des trajets (7).
